# EUROPEAN PATENT APPLICATION

(11) **EP 3 796 088 A1**
(43) Date of publication of application: **24.03.2021**
(21) Application number: 19198917.7
(22) Date of filing: 23.09.2019
(51) Int. Cl.: G03F 7/20

(54) **METHOD AND APPARATUS FOR LITHOGRAPHIC PROCESS PERFORMANCE DETERMINATION**

(71) Applicant: ASML Netherlands B.V., 5500 AH Veldhoven (NL)
(72) Inventor: WERKMAN, Roy, 5500 AH Veldhoven (NL); LAM, Pui, Leng, 5500 AH Veldhoven (NL); MINGHETTI, Blandine, Marie, Andree, Richit, 5500 AH Veldhoven (NL)
(74) Representative: ASML Netherlands B.V.

(57) **Abstract**

A method and apparatus for determining a performance of a lithographic patterning process. The method comprises receiving an image of a portion of a substrate, the portion of the substrate comprising a first region comprising first features associated with a first lithographic exposure of the substrate at a first time, and a second region comprising second features associated with a second lithographic exposure the substrate at a second time. The intended locations of the first region and the second region do not overlap. The method further comprises determining the performance of the lithographic patterning process based on one or more feature characteristics of the first and/or second exposed features at a boundary between the first region and the second region.

## Description

### FIELD

The present invention relates apparatuses and methods for determining performance of a lithographic patterning process. In particular, it relates to determination of a performance of a lithographic patterning process based on characteristics of a boundary between first and second regions.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Patterning of a layer on a substrate may comprise a multiple steps. For example, a patterning device, such as a mask, may not be big enough to pattern a substrate in one position. In some cases, the pattern to be exposed may fit into a single mask. The single mask may then be moved across the substrate, to expose the same pattern multiple times onto the same substrate. In other cases, the pattern to be exposed onto the substrate, for example a pattern forming a device, may be too big to fit on a single mask. Several masks, each comprising a different portion of the pattern to be exposed, may be moved across the substrate in multiple independent steps. The multiple masks be moved across regions of a substrate, to pattern different portions of the pattern sequentially. This breaking up of a pattern across different regions on a substrate may give rise to positioning errors of the exposed portions of the pattern on the substrate, relative to each other. An exposed pattern may comprise for example alignment and/or magnification errors. Due to the small dimensions of patterned features, high precision and accuracy may be required in positioning different patterned regions relative to each other. Errors in the relative positions may be referred to as stitching errors. Stitching errors may affect the quality of exposed pattern on a substrate, and the resulting yield of the patterning process. It is therefore desirable to provide methods and apparatuses to reduce stitching errors and their negative effects on lithographic patterning processes.

### SUMMARY

According to a first aspect of the disclosure, there is provided an apparatus for determining a performance of a lithographic patterning process, the apparatus comprising one or more processors configured to receive an image of a portion of a substrate, the portion of the substrate comprising a first region comprising first features associated with a first lithographic exposure of the substrate at a first time, and a second region comprising second features associated with a second lithographic exposure of the substrate at a second time, wherein the first and second regions do not overlap. The one or more processors are further configured to determine the performance of the lithographic patterning process based on one or more feature characteristics of the first and/or second exposed features associated with a boundary between the first region and the second region.

Optionally, the boundary may comprises a portion of an outer border of the first region and a portion of an outer border of the second region.

Optionally, the first features and the second features may comprise at least one of product features, and dummy features having one or more dimensions the same as the product features.

Optionally, the first features and the second features may form a single feature extending along at least part of the first region and at least part of the second region.

Optionally, the one or more feature characteristics may comprise a distance metric comprising a distance between one or more axes of symmetry of the first features and one or more axes of symmetry of the second features, and/or a physical distance between the first features and the second features.

Optionally, the one or more feature characteristics may comprise a narrowing or a thickening of the single feature at or proximal to the boundary.

Optionally, the first features and the second features may form part of a patterned layer of photoresist or a layer of material after being patterned by an etching process.

Optionally, determining the performance may comprise analysing the image to determine one or more feature characteristics of the first and/or second features associated with the boundary between the first region and the second region.

Optionally, determining the performance may comprise performing a comparison of the first and/or second features of the image to a standard for the first and/or second features.

Optionally, determining the performance may further comprises determining a performance of one or more lithographic patterning process characteristics, based on the determined one or more feature characteristics.

Optionally, the one or more feature characteristics may comprise a spatial dimension of the first and/or second features.

Optionally, the one or more process characteristics may comprise one or more of magnification, translation, and/or a higher order deformation error associated with the patterning of the first region and/or the second region.

Optionally, the performance of the one or more process characteristics may be determined at least in part using a model taking as input at least one of the one or more feature characteristics.

Optionally, the model may comprise a machine learning model.

Optionally, the model may comprise a neural network.

Optionally, the model may comprise vision technology.

Optionally, the first region and the second region may form part of a same device on the substrate.

Optionally, the first region may be a first field exposed on the substrate, and the second region may be a second field exposed on the substrate. The boundary may comprise a portion of a border of the first field and a border of the second field.

Optionally, determining the performance may comprises determining a stitching error between the first field and the second field.

Optionally, the received image may comprise the substrate in between exposure of subsequent layers on the substrate.

Optionally, the received image may comprise a boundary between the first and second regions extending in at least one direction.

Optionally, the processor may be configured to receive a plurality of images, and determine the quality of the patterning process based on the plurality of images.

Optionally, the plurality of images comprise a first image comprising a boundary between the first and second regions in a first direction, and a second image comprising a boundary between the first region and a further region in a second direction. The first direction and the second direction may be not parallel to each other.

Optionally, the first direction and the second direction may be substantially perpendicular to each other.

Optionally, the one or more processors may be further configured to determine a performance of one or more process characteristics for the first image, and to determine one or more process characteristics for the second image. The one or more processors may be further configured to combine the one or more process characteristics of the first and second images to determine a performance of the patterning process.

Optionally, the plurality of images may depict a plurality of separate positions on the substrate.

Optionally, one or more process characteristics may be determined for the separate positions on the substrate.

Optionally, the one or more processors may be further configured to determine one or more corrections to the patterning process based on the performance of the lithographic patterning process.

Optionally, the one or more processors may be further configured to update the lithographic patterning process with the one or more corrections.

Optionally, updating the lithographic patterning process may comprise updating at least one of one or more exposure settings of a lithographic apparatus, and a reticle design.

Optionally, the lithographic patterning process may be configured to pattern a substrate using a reticle and electromagnetic radiation.

Optionally, the one or more processors may be further configured to control a metrology apparatus to obtain the image.

Optionally, controlling a metrology apparatus to obtain the image may comprise guiding the metrology apparatus is based on previously determined one or more feature characteristics.

Optionally, the metrology apparatus may comprise an electron beam imager.

According to another aspect of the disclosure, there is provided a method for determining a performance of a lithographic patterning process. The method comprises receiving an image of a portion of a substrate, the portion of the substrate comprising a first region comprising first features associated with a first lithographic exposure of the substrate at a first time, and a second region comprising second features associated with a second lithographic exposure of the substrate at a second time, wherein the first and second regions do not overlap. The method further comprises determining the performance of the lithographic patterning process based on one or more feature characteristics of the first and/or second exposed features associated with a boundary between the first region and the second region.

Optionally the boundary comprises a portion of an outer border of the first region and a portion of an outer border of the second region.

Optionally, the first features and the second features may comprise at least one of product features, and dummy features having one or more dimensions the same as the product features.

Optionally, the first features and the second features may form a single feature extending along at least part of the first region and at least part of the second region.

Optionally, the one or more feature characteristics may comprise a distance metric comprising a distance between one or more axes of symmetry of the first features and one or more axes of symmetry of the second features, and/or a physical distance between the first features and the second features.

Optionally, the one or more feature characteristics may comprise a narrowing or a thickening of the single feature at or proximal to the boundary.

Optionally, the first features and the second features may form part of a patterned layer of photoresist or a layer of material after being patterned by an etching process.

Optionally, determining the performance may comprise analysing the image to determine one or more feature characteristics of the first and/or second features associated with the boundary between the first region and the second region.

Optionally, determining the performance may comprise performing a comparison of the first and/or second features of the image to a standard for the first and/or second features.

Optionally, determining the performance may further comprise determining a performance of one or more lithographic patterning process characteristics, based on the determined one or more feature characteristics.

Optionally, the one or more feature characteristics may comprise a spatial dimension of the first and/or second features.

Optionally, the one or more process characteristics may comprise one or more of magnification, translation, and/or a higher order deformation error associated with the patterning of the first region and/or the second region.

Optionally, the performance of the one or more process characteristics may be determined at least in part using a model taking as input at least one of the one or more feature characteristics.

Optionally, the model may comprise a machine learning model.

Optionally, the model may comprise a neural network.

Optionally, the model may comprise vision technology.

Optionally, the first region and the second region may form part of a same device on the substrate.

Optionally, the first region may be a first field exposed on the substrate, the second region may be a second field exposed on the substrate. The boundary may comprises a portion of a border of the first field and a border of the second field.

Optionally, determining the performance may comprise determining a stitching error between the first field and the second field.

Optionally, the received image may comprise the substrate in between exposure of subsequent layers on the substrate.

Optionally, the received image may comprise a boundary between the first and second regions extending in at least one direction.

Optionally, the method may further comprise receiving a plurality of images, and determining the quality of the patterning process based on the plurality of images.

Optionally, the plurality of images may comprise a first image comprising a boundary between the first and second regions in a first direction, and a second image comprising a boundary between the first region and a further region in a second direction. The first direction and the second direction may be not parallel to each other.

Optionally, the first direction and the second direction may be substantially perpendicular to each other.

Optionally, the method may further comprise determining a performance of one or more process characteristics for the first image, and determining one or more process characteristics for the second image. The method may further comprise combining the one or more process characteristics of the first and second images to determine a performance of the patterning process.

Optionally the plurality of images may depict a plurality of separate positions on the substrate.

Optionally, one or more process characteristics may be determined for the separate positions on the substrate.

Optionally, the method may further comprise determining one or more corrections to the patterning process based on the performance of the lithographic patterning process.

Optionally, the method may further comprise updating the lithographic patterning process with the one or more corrections.

Optionally, updating the lithographic patterning process may comprise updating at least one of one or more exposure settings of a lithographic apparatus, and a reticle design.

Optionally, the lithographic patterning process may be configured to pattern a substrate using a reticle and electromagnetic radiation.

Optionally, the method may further comprise controlling a metrology apparatus to obtain the image.

Optionally, controlling a metrology apparatus to obtain the image comprises guiding the metrology apparatus may be based on previously determined one or more feature characteristics.

Optionally, the metrology apparatus may comprise an electron beam imager.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a flow diagram of steps in a method of determining a performance of a lithographic patterning process;
- Figure 5 depicts a schematic representation of a portion of a substrate comprising first and second regions with first and second features;
- Figure 6 depicts a schematic representation of a portion of a substrate comprising a plurality of features;
- Figure 7 depicts a schematic representation of images obtained across a portion of a substrate;
- Figure 8 depicts a flow diagram of steps in a method of determining a performance of lithographic patterning process.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

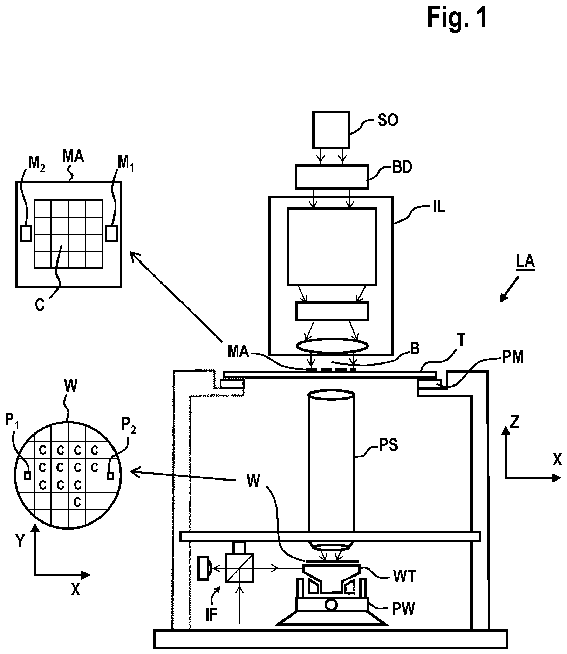

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

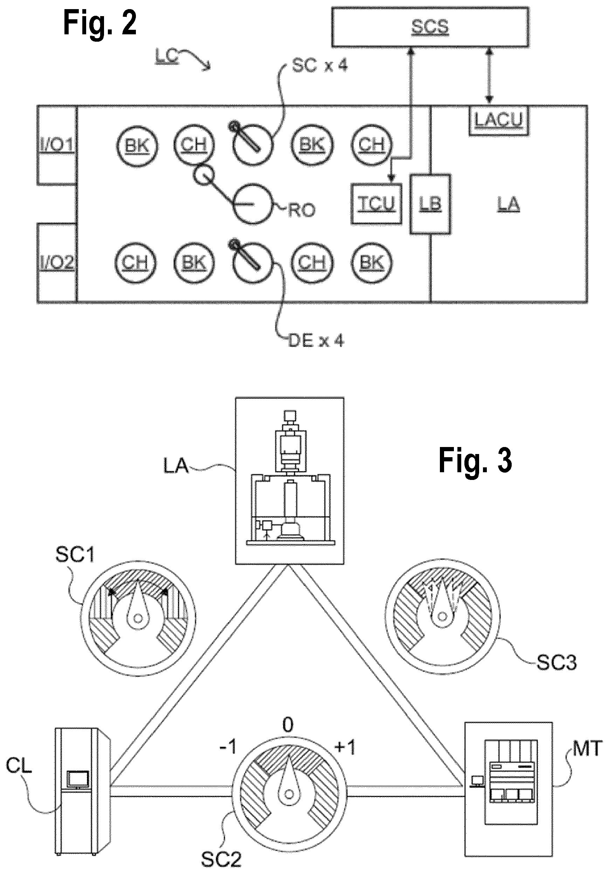

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation, which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

Different regions on a substrate may be exposed sequentially. For example, a reticle, or mask, may comprise a pattern to be exposed on a substrate a plurality of times. When exposing a layer on the substrate, the reticle may be moved relative to the substrate, in order to expose different regions on the substrate sequentially. As discussed above, a reticle may be associated with to a first positioner PM for accurately positioning the reticle inside a lithographic apparatus LA. A substrate W may be associated with a second positioner PW for accurately positioned the substrate W inside lithographic apparatus LA. The positioners PM and PW may be used to accurately position a substrate W and reticle relative to each other, in order to set a position of an exposed pattern on the substrate. Other settings and elements that may affect the position of a pattern on a substrate may include for example, the projection system PS for projecting the pattern of the reticle onto the substrate W, properties (e.g. topography) of the substrate, wafer table, WT, and properties of the radiation used for exposing a pattern.

In an example implementation, a full device to be lithographically exposed may be too big to fit on a single reticle. The full device may therefore be divided into two or more separate regions. The regions may be exposed separately from each other, for example sequentially. In order for the full device to work, the separately exposed regions need to be connected accurately and precisely at or proximal to a boundary between regions.

In order to position a plurality of sequentially patterned regions accurately, relative to each other, precise parameter control may be required. Settings of different elements of the lithographic apparatus LA may be optimised in order to obtain accurate positioning of exposed regions on the substrate. Measurement data may be obtained of an exposed substrate for determining the positioning of a plurality of regions. Measurement data may be used to check whether an exposed substrate has acceptable positioning of exposed regions, e.g. for quality control. Measurements may also be used to determine how to improve settings for future exposures performed by the lithographic apparatus LA. For example, positioning errors may be determined for a plurality of regions. The determined positioning errors may indicate that there is an error in the x-direction alignment of two neighbouring regions. The error may be analysed to determine one or more causes of the error. One or more apparatus or recipe settings may be updated to address the error, in order to avoid the mistake in future exposures.

Positioning of sequentially exposed regions relative to each other may be discussed in relation to stitching errors. The performance of a lithographic patterning process may comprise one or more stitching errors. Stitching errors may be errors in the desired position of exposed regions. Stitching may refer to the connection, or relative placement, of two regions. The regions may be neighbouring regions. The regions may comprise features having an association with each other. For example, the regions may belong to a same device exposed on the substrate W. The lithographic exposure may expose a pattern onto a two-dimensional region. The region may be rectangular. For example, a region may be square. However, the region may have any two-dimensional shape in the plane of the substrate. Along the borders of a region, a boundary with a neighbouring region may exist. In the case of a rectangular region, the directions along which the borders of a region lie may be referred to as the x-direction and y-direction. The directions of the borders may also be referred to as a horizontal and vertical directions.

As described above, the in-plane placement of exposed regions on a substrate may be controlled using measurement data. Measurement data may for example be used to determine and/or analyse stitching errors between regions on a substrate W. The measurement data may be obtained based on a metrology target. The metrology target may for example be an overlay metrology target. One or more metrology targets may be positioned on substrate as part of a pattern design exposed on the substrate. A metrology target may be exposed as part of the lithographic exposure. The structures included in the target (e.g. diffraction gratings) may be analysed to determine properties of the exposed pattern. Analysis of the metrology target(s) may comprise measurements to determine a position of one or more metrology targets relative to one or more further metrology targets on the substrate. The measurements may comprise for example overlay and/or alignment measurements. The metrology target(s) and further metrology target(s) may be positioned in different regions on the substrate. Including metrology targets adds costs by taking up space on the substrate W, as it leads to less space being available for exposing product features. On the other hand, including less metrology targets on a substrate may lead to sparse metrology data being available. This may in turn lead to decreased quality of analysis and/or control of the exposed patterns. Another potential drawback of using metrology targets for determining in-plane placement of regions, is that the measurement data may not be representative of the actual stitching error for the exposed features. The metrology target measurements may for example be designed and/or the pattern built up in a different way, meaning their behaviour is different. For example, the response of the pattern to aberrations and/or process effects of the exposure process may be different. The limited availability of metrology data, and the potential discrepancy between stitching error data and actual stitching errors, may present drawbacks for using metrology targets for in-plane positioning control. Described herein are methods and apparatuses to overcome at least some of these challenges.

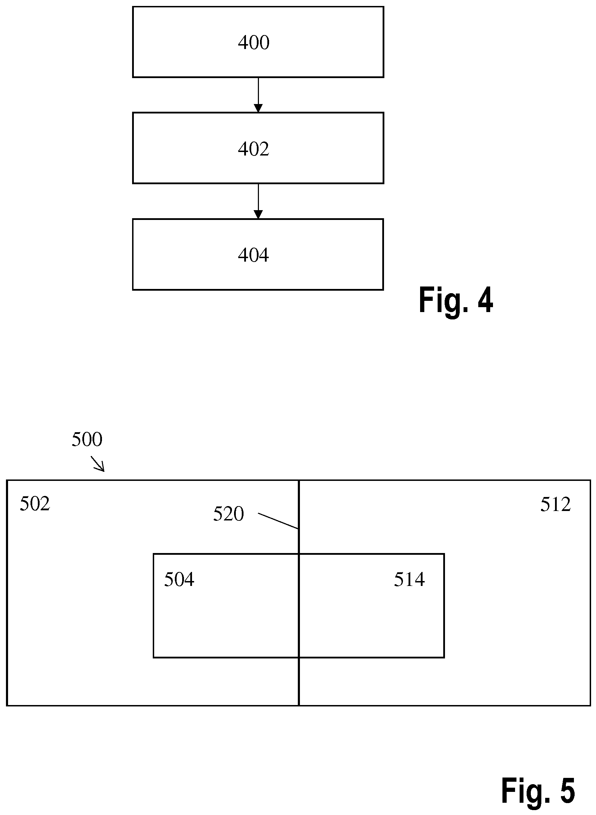

Figure 4 depicts a flow diagram with steps in a method of determining a performance of a lithographic patterning process. The performance may be related to stitching of neighbouring exposed regions on a substrate. In step 400, at least one image of a portion of a substrate may be received. The portion of the substrate may comprise a first region comprising first features associated with a first lithographic exposure of the substrate at a first time. The portion of the substrate may further comprise a second region comprising second features associated with a second lithographic exposure of the substrate at a second time. The first and second regions may each comprise a portion that does not overlap with the other of the first and second regions. In a next step 402, one or more feature characteristics of the first and/or second exposed features may be obtained. The first and/or second exposed features may be associated with a boundary between the first and second regions. The first and/or second exposed features may for example be located at a boundary between the first region and the second region. In step 404 the performance of the lithographic patterning process may be determined based on the feature characteristics. The method described above, and other methods described herein, may be performed by an apparatus comprising one or more processors configured to perform the steps of the methods described herein.

Figure 5 depicts a schematic representation of an image of a portion 500 of a substrate comprising first region 502 and second region 512. The first region 502 and the second region 512 may be separated along a boundary 520. The boundary 520 may comprise an outer border of first region 502 and an outer border of second region 512.

The first region 502 may comprise first features 504 associated with the first lithographic exposure. The second region 512 may comprise second features 514 associated with a second lithographic exposure. The first 502 and second 512 regions may be first and second exposure fields of a lithographic exposure process. The boundary 520 may comprise all or part of a border of the first field and all or part of a border of the second field. The first and second lithographic exposures may have been performed sequentially, at first and second times. Further exposures may have been performed between the first exposure and the second exposure. For example, one or more further regions may have been exposed lithographically, in between the first and second lithographic exposures of the first and second regions.

The first region 502 and the second region 512 may be neighbouring regions. The intended design of the first region 502 and the second region 512 may be nominally not overlapping. For example, a portion of outer border of the first region 502 may abut a portion of an outer border of the second region 512. However, in practice, the first region 502 and the second region 512 may partially overlap, for example because of errors in the patterning exposure, such as a stitching error. In other implementations, the first 502 and second 512 regions may have a partial overlap on the substrate. The first 502 and second 512 regions may have substantially the same size and/or shape. The shape of a region may be rectangular. The shape of a region may for example be square. A region may correspond to an exposure field on the substrate. One or more dimensions of a region may be in the range of 10 mm to 35 mm. For example, a region may correspond to an exposure field with dimensions of 26 mm by 33 mm, or 23 mm by 23 mm.

Determining the performance of a lithographic patterning process may comprise determining a quality of the patterning process. The quality may relate to how different regions that were exposed separately to each other are positioned relative to each other. Determining a performance may comprise determining a stitching error between a first exposure field 502 and a second exposure field 512. Determining a performance may comprise determining one or more properties of the exposed pattern, wherein the properties may be referred to as process features. Determining a performance may comprise determining one or more corrections for the patterning process. The corrections may be based on the determined process features and/or performance of the lithographic patterning process. The determined corrections may be used to update the lithographic patterning process for future iterations. Determining the performance of a lithographic patterning process may also comprise a verification of the patterning process.

The image may be a scanning electron microscope image (SEM). The image may be a voltage contrast image. A voltage contrast image may provide a measure of the electrical contact of features to the underlying layer. The image may be obtained after the exposed substrate has been processed, for example after one or more post-exposure development steps performed on the patterned substrate. The measure of contact to an underlying layer may provide an indication of how well the features of the exposed layer match up with features of an underlying layer. This may in turn be used to determine whether a stitching error is present. The image may be obtained while the substrate is in the lithographic cell LC. The image may be of a patterned layer of photoresist on the substrate. The image may be of a layer of material that has been patterned by an etching process.

The first features 504 and/or the second features 514 may be product features. That is to say, the method may use characteristics of features exposed on the substrate that are not related to a metrology target. The features 504, 514 may relate to a product structure to be exposed and patterned onto the substrate. For example, a substrate may be patterned with one or more devices. The first 504 and second 514 features may form part of the same device patterned on the substrate. The first features 504 and the second features 514 may be located in areas that have a common bounary. The common boundary may comprise some or all of boundary 520 between the first 502 and second 512 regions. An advantage of this method may be that the performance of the process is determined based on analysis of product features itself, as opposed to for example metrology target features. Another advantage may be that no or less metrology targets may be required, which may free up space on the substrate for product features. As more product features may be present on a substrate compared to metrology targets, using images of product features for analysis may allow taking dense measurements. This may result in a more detailed analysis of the performance, which may lead to increased accuracy. Because the analysis is not limited to areas of the substrate where metrology targets are present, the distribution and/or density of measurements may be tailored across the substrate. For example, areas of the exposed pattern where stitching is important for performance, or areas where past exposures have experienced stitching errors, may be measured more densely compared to other areas.

The first features 504 and/or the second features 514 may be dummy features. Dummy features may be exposed on a substrate to have similar properties and/or dimensions to product features. In this respect, one or more properties and/or dimensions of dummy features may be the same or substantially the same as corresponding properties and/or features of one or more product features. This may be so that analysis of the dummy features would provide similar results to analysis of product features. For example, the dummy features may have similar dimensions and/or shapes to product features. In some instances, the shapes of dummy features may be set so that feature characteristics may be obtained that may be suitable for analysis to determine the performance. For example, the dummy features may comprise a variety of different features that may resemble product features from across the substrate, so that the variety of features may be found within a single image. Properties of dummy features may be designed to increase the sensitivity of the features to stitching errors. For example, the shape, dimensions, position, or dose of dummy features may be set so that they are sensitive to variations in stitching.

The first features 504 and the second features 514 may be first product features and second product features, respectively. In some instances, the first 504 and second 514 features may form part of different product features. In other instances, the first 504 and second 514 features may nominally comprise a single feature extending along the first region and the second region. Stated otherwise, the first features 504 and the second features 514 may comprise portions of the same product feature extending across the boundary between the first 502 and second 512 regions. An image may comprise a combination of first and second features comprising separate product features, and first and second features comprising a single product feature.

Determining the performance of a lithographic patterning process may comprise performing an analysis of the image to determine one or more feature characteristics. Analysis of the image may be used to determine feature characteristics of the first features 504 and/or the second features 514. The first and or second features may be associated with the boundary comprised in the image. In this context, associated with may mean the features are positioned at or near (proximal to) the boundary between the first and second regions. The feature characteristics may comprise a visual property of the first and/or second features in the image. The feature characteristics may comprise a spatial dimension of the first and/or second features. The feature characteristic may comprise a distance metric, which may be between the first features 504 and the second features 514. The distance metric may for example comprise a distance between one or more axes of symmetry of the first features 504 and one or more axes of symmetry of the second features 514. In case the first features and the second features do not constitute a single feature extending along the first 502 and second 512 regions, the distance metric may comprise a physical distance between the first features and the second features.

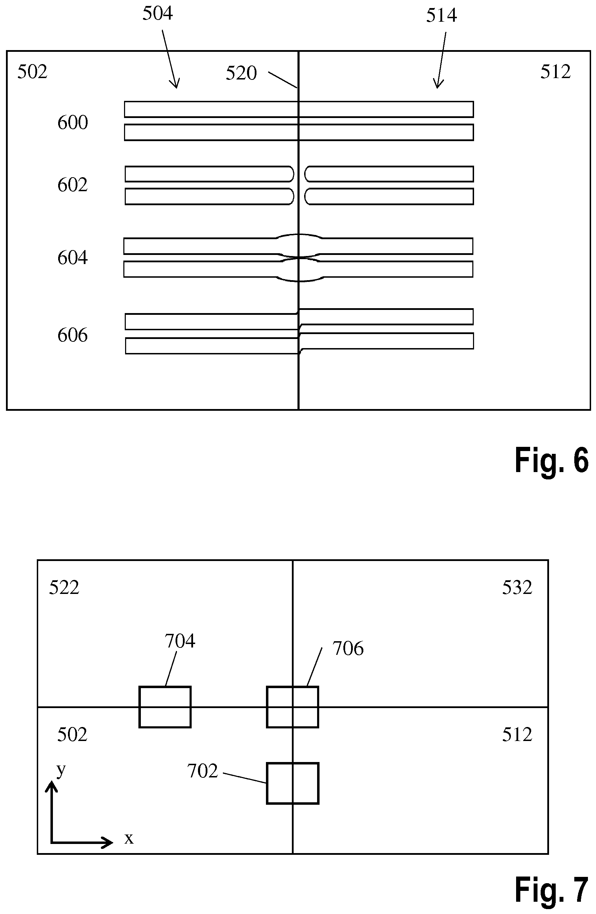

Figure 6 depicts a schematic representation of several example feature characteristics. The feature characteristics in the first 502 and second 512 regions comprise a single example feature, consisting of two parallel lines crossing over boundary 520 between the first 502 and second 512 regions. The intended feature design to be exposed onto a substrate may be referred to as a design standard. Determining feature characteristics may involve comparing one or more spatial dimensions and/or other visual properties of a feature exposed on the substrate, to the design standard. Feature 600 may represent a feature according to the design standard of two parallel lines. Feature 600 does not comprise a stitching error. Single features crossing a boundary 520 may comprise a local thickening or narrowing at or proximal to the boundary between the first region 502 and the second region 512. In feature 602 the parallel lines are interrupted at boundary 520, so that they do not meet to form a solid line. Although feature 602 shows a full interruption of the parallel lines, in some instances the lines may instead experience a local narrowing around the boundary region 520. In feature 604, the parallel lines are wider (or thicker) around the boundary region 520. In feature 606 the lines in the second region 512 are displaced or offset in the direction parallel to the boundary 520, compared to the lines of the first region 502. If the stitching of the regions comprises an error, the performance of the resulting device may be reduced. For example, first features 504 and second features 514 may be designed to contact each other across boundary 520 for allowing current to flow between them. However, due to a stitching error, there may be a reduced contact or no contact between the first 504 and second 514 features. This may least to a reduced connection or no connection being made, inhibiting current flow. In some instances, a stitching error may cause the regions to have partial overlap, which may increase the size of the exposed features. This may cause features that are not supposed to contact to overlap, which may for example cause a short circuit.

Determining the performance of a lithographic patterning process may comprise determining the performance of one or more lithographic patterning process characteristics, also referred to as process characteristics. The determined feature characteristics may be used to determine one or more process characteristics. Example process characteristics include translation in the x and/or y directions, magnification, focus, dose, etc. in the first region 502 and/or the second region 512. Example process characteristics may also comprise one or more higher order deformation errors associated with patterning of the first regions 502 and/or the second region 512. In figure 6, the narrowing and/or interruption of the parallel line at boundary 520 may indicate that the magnification of the exposed features in the first 502 and/or second 512 regions is too small. The local thickening of the lines at boundary 520 in feature 604 may indicate that the magnification of the exposed pattern in the first 502 and/or second 512 regions is too large. Feature 604 may indicate a translation error of the first region 502 relative to the second region 512 along the dimension parallel to boundary 520.

A combination of analyses of multiple feature characteristics may be used to determine process features. This may for example comprise an analysis of features characteristics for differently shaped features in the first 502 and/or second 512 regions. Example features include straight lines, dots, larger area features, etc. The lines may be perpendicular to the boundary 520, or the lines may be positioned at a non-perpendicular angle to the boundary 520. A combination of differently shaped features may for example be obtained by exposing and imaging dummy features on a substrate.

Determining process characteristics may also be performed based on feature characteristics obtained from a plurality of images. For example, in order to determine the quality of stitching around a region, images of different parts along the boundary may be used. Different images may provide a boundary along different in-plane dimensions on the substrate. For example, a first image may be provided comprising a first boundary between a first region and a second region. A second image may be provided comprising a second boundary having a different direction to the first boundary. The second boundary may be between the first region and a further region. The further region may be the second region (same as for the first boundary), or a third region, associated with a third lithographic exposure on the substrate at a third time, separate from the first and second exposures.

A plurality of images may be received for determining a performance of a patterning process. A first image and a second image may comprise boundaries in first and second directions, wherein the first and second directions are not parallel. The first and second directions may be perpendicular. The first image and the second image may both comprise a boundary comprising a portion of an outer border of a first region 502. For example, in the case of a rectangular region, a first image may be received comprising a portion of a boundary in the x-direction, and a second image may be received comprising a portion of a boundary in the y-direction. The x- and γ-directions may form the plane of the substrate.

Figure 7 depicts a schematic representation of a portion of a substrate comprising regions 502, 512, 522, 532. Each of the regions 502, 512, 522, 532 may have been lithographically exposed at a different time. Each of the regions 502, 512, 522, 532 may be a separate exposure field. A first image 702 may be provided, comprising a boundary between region 502 and region 512. The boundary of image 702 may extend in the y-direction. A second image 704 may be provided, comprising a boundary between region 502 and region 522. The boundary of the second image may extend in the x-direction. One or more process characteristics may be determined for the first image 702 and the second image 704 separately. The process characteristics from the first 702 and second 704 image may then be combined to determine a performance of the patterning process. As well as using two images, process features determined from three or more images may be combined to determine a performance of the patterning process. Alternatively or additionally, an image 706 may be provided of a corner portion of region 502. This image may comprise a portion of boundaries in both x- and y-directions.

The method of analysing and determining a performance of a lithographic patterning process may be performed for multiple layers on the same substrate. The image may be taken of the substrate in between subsequent exposure steps. The performance may be analysed after every exposure that comprises stitching of regions on the substrate. An advantage of the methods described herein may be that they enable the substrate to be measured for example by obtaining an SEM image. This may increase the speed of the process of determining the performance of the lithographic patterning process compared to diffraction-based measurements, which are slow to obtain compared to SEM metrology.

The determined process features may be used to determine the performance of the lithographic patterning process. The performance may comprise for example an assessment of the quality of the process, a verification of the features exposed by the process, and/or a determined stitching error for the exposure. The method may also determine one or more corrections to the lithographic patterning process. The lithographic patterning process may be updated with the one or more corrections for future iterations. Updating the patterning process may comprise updating at least one or more exposure settings of the lithographic apparatus LA, and a reticle design.

The method may receive a plurality of images spread across different positions on the substrate for determining the performance of a lithographic patterning process. Determining the performance of the lithographic patterning process may comprise determining an overall quality of the exposure, and/or may comprise a localised assessment of the quality. Process characteristics may be determined for each of the images, and may be combined for determining an overall quality of the lithographic patterning process. In other implementations, one or more images located closely together on the substrate may be combined to determine a separate, localised, determination of the process performance at that position on the substrate. The feature characteristics and process characteristics may be determined at different positions on a substrate, as stitching errors may vary across a substrate. This may be used to determine stitching errors across different positions on the substrate. This may allow the performance of the lithographic patterning process to be determined across the substrate. If the performance is measured on product features, the method may provide flexibility in the amount of images analysed to determine the process performance. The density of measurements may be set depending on the requirements of the performance analysis, e.g. the precision and accuracy required for the product features exposed on the substrate. The method may determine a dense map or a sparse map of performance across the substrate. A substrate may comprise in the order of 100 regions. The method may determine a performance for a number of regions between five regions and all regions on the substrate. The measurements may be spread evenly across the regions of the substrate. For example, if there are four measurement locations per region (e.g. 4 metrology targets), each of the measurement locations may be used for 25% of the regions. Per region, a plurality images may be obtained for determining stitching errors. The images may relate to the same boundary having the same first 502 and second 512 regions, or to different boundaries between a first region 502, and second 512, third 522, fourth 523, etc. regions. The method may use between 4 and 20 images per region. In some instances, the method may use more than 20 images.

The same lithographic patterning exposure may be performed on a plurality of substrates over a period of time. The amount and positions of images to be analysed for determining the performance of the patterning process may be changed over time. When a new exposure pattern starts, a more dense performance map may be prepared, as the new process may require more corrections initially. Once the process settings have been corrected one or more times, the performance may improve, and/or stabilise. In response to this, the amount of images analysed to determine process performance may be reduced. The method may also be flexible how dense the performance analysis is across the substrate. The method may determine one or more areas of interest for performance analysis. For example, areas where the determined performance is worse may be analysed in more detail when performing that same exposure on another substrate. As another example, a substrate may comprise critical areas, where product features may have more stringent fabrication requirements (i.e. lower tolerances on deviations from the design standard). These critical areas may receive more dense performance monitoring. This may lead to improved performance of the patterning process at the critical areas.

The methods of determining a performance of a lithographic patterning process may be determined in whole or in part using a model. The model may comprise vision technology, for example machine vision technology. The model may be a machine learning model. A model may be used to determine one or more process characteristics. In an example implementation, a model may receive one or more feature characteristics as input. In another example implementation, a model may take as input one or more received images of the first and second region and boundary 520. A method may use a plurality of models. A method may for example use two separate models. A first model may be a vision technology model. The vision technology model may be used for interpreting one or more images provided as input to the model. A model receiving one or more images as input may be a convolutional neural network. The first model may provide one or more process characteristics as output. A second model may receive one or more process characteristics determined by the first model. The second model may receive process characteristics for a plurality of regions on a substrate. The second model may interpret the received process characteristics to convert them to patterning corrections. The second model may provide as output, correction data for adjusting the lithographic patterning process, for example for correcting stitching errors. For example, the correction data may comprise one or more updated values for lithographic patterning process settings. A model may the model may comprise a classification model. The classification model may for example be for verification of the patterning process. For example, the model may classify an image as having region stitching properties falling within (pass) or outside (fail) of one or more set exposure tolerances.

In some instances, the one or more images may be obtained by an entity controlled separately from the method described herein. In other instances, the method may include controlling a metrology tool MT to obtain one or more images of the substrate. The one or more images of the exposed regions on the substrate may be for example a scanning electron microscope (SEM) images, or voltage contrast images. The metrology tool MT may be an electron beam imager. The results of a previous performance determination may be used to guide a metrology apparatus to obtain images on the substrate. As described above in more detail, the results of previous performance determination may be used to determine which images to obtain, for example based on determined areas of interest. This previous performance information may guide where on the substrate to obtain images, and/or the density of the images across the substrate.

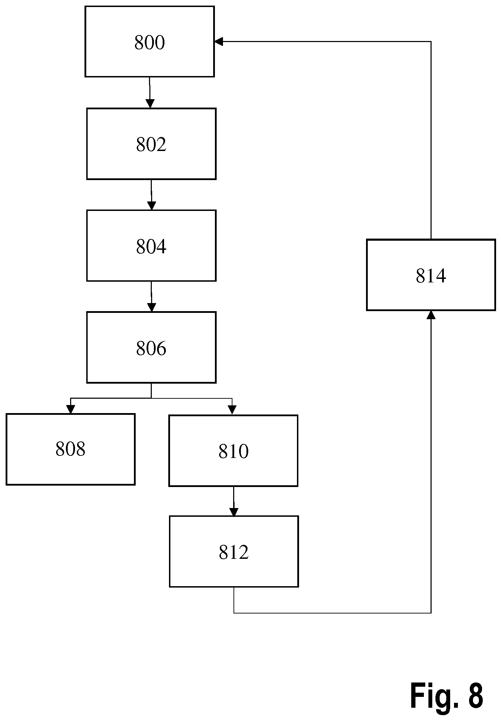

Figure 8 depicts a flow diagram of steps in an example method for determining the performance of a lithographic patterning process. In step 800 one or more images are received of portions of a substrate comprising first 502 and second 512 regions, as described above. In step 802, the one or more images may be analysed to determine one or more feature characteristics of product and/or dummy features exposed on the portion of the substrate shown on the image. In step 804, the feature characteristics may be analysed to determine one or more process characteristics of the lithographic patterning process. In step 806 the performance of the lithographic pattering process may be determined based on the determined process characteristics. Determining the performance may comprise a verification of the patterning process 808. The determined performance may also comprise determining (810) one or more process corrections, and updating 812 the lithographic patterning process for future iterations. The method may also comprise controlling and/or guiding 814 a metrology tool MT for obtaining images for a determination of the performance of a future iteration of the lithographic patterning process.

Further embodiments of the invention are disclosed in the list of numbered clauses below:
1. An apparatus for determining a performance of a lithographic patterning process, the apparatus comprising one or more processors configured to:
   receive an image of a portion of a substrate, the portion of the substrate comprising a first region comprising first features associated with a first lithographic exposure of the substrate at a first time, and a second region comprising second features associated with a second lithographic exposure of the substrate at a second time, wherein the first and second regions do not overlap;
   determine the performance of the lithographic patterning process based on one or more feature characteristics of the first and/or second exposed features associated with a boundary between the first region and the second region.
2. An apparatus according to clause 1, wherein the boundary comprises a portion of an outer border of the first region and a portion of an outer border of the second region.
3. An apparatus according to any of the preceding clauses, wherein the first features and the second features comprise at least one of product features, and dummy features having one or more dimensions the same as the product features.
4. An apparatus according to any of the preceding clauses, wherein the first features and the second features form a single feature extending along at least part of the first region and at least part of the second region.
5. An apparatus according to any of the preceding clauses, wherein the one or more feature characteristics comprise a distance metric comprising:
   a distance between one or more axes of symmetry of the first features and one or more axes of symmetry of the second features; and/or
   a physical distance between the first features and the second features.
6. An apparatus according to clause 4, wherein the one or more feature characteristics comprise a narrowing or a thickening of the single feature at or proximal to the boundary.
7. An apparatus according to any of the preceding clauses, wherein the first features and the second features form part of a patterned layer of photoresist or a layer of material after being patterned by an etching process.
8. An apparatus according to any of the preceding clauses, wherein determining the performance comprises analysing the image to determine one or more feature characteristics of the first and/or second features associated with the boundary between the first region and the second region.
9. An apparatus according to clause 8, wherein determining the performance comprises performing a comparison of the first and/or second features of the image to a standard for the first and/or second features.
10. An apparatus according to clause 8 or 9, wherein determining the performance further comprises determining a performance of one or more lithographic patterning process characteristics, based on the determined one or more feature characteristics.
11. An apparatus according to clause 10, wherein the one or more feature characteristics comprise a spatial dimension of the first and/or second features.
12. An apparatus according to clause 10 or 11, wherein the one or more process characteristics comprise one or more of magnification, translation, and/or a higher order deformation error associated with the patterning of the first region and/or the second region.
13. An apparatus according to any of clauses 10 to 12, wherein the performance of the one or more process characteristics is determined at least in part using a model taking as input at least one of the one or more feature characteristics.
14. An apparatus according to clause 13, wherein the model comprises a machine learning model.
15. An apparatus according to clause 14, wherein the model comprises a neural network.
16. An apparatus according to clause 15, wherein the model comprises vision technology.
17. An apparatus according to any of the preceding clauses, wherein the first region and the second region form part of a same device on the substrate.
18. An apparatus according to any of the preceding clauses, wherein the first region is a first field exposed on the substrate, the second region is a second field exposed on the substrate;
   and wherein the boundary comprises a portion of a border of the first field and a border of the second field.
19. An apparatus according to clause 18, wherein determining the performance comprises determining a stitching error between the first field and the second field.
20. An apparatus according to any of the preceding clauses, wherein the received image comprises the substrate in between exposure of subsequent layers on the substrate.
21. An apparatus according to any of the preceding clauses, wherein the received image comprises a boundary between the first and second regions extending in at least one direction.
22. An apparatus according to any of the preceding clauses, wherein the processor is configured to receive a plurality of images, and determine the quality of the patterning process based on the plurality of images.
23. An apparatus according to clause 22, wherein the plurality of images comprise a first image comprising a boundary between the first and second regions in a first direction, and a second image comprising a boundary between the first region and a further region in a second direction, and wherein the first direction and the second direction are not parallel to each other.
24. An apparatus according to clause 23, wherein the first direction and the second direction are substantially perpendicular to each other.
25. An apparatus according to any of clause 23 - 24, wherein the one or more processors are further configured to determine a performance of one or more process characteristics for the first image, and to determine one or more process characteristics for the second image; and
   combine the one or more process characteristics of the first and second images to determine a performance of the patterning process.
26. An apparatus according to any of clauses 22 - 25, wherein the plurality of images depict a plurality of separate positions on the substrate.
27. An apparatus according to clause 26, wherein one or more process characteristics are determined for the separate positions on the substrate.
28. An apparatus according to any of the preceding clauses, wherein the one or more processors are further configured to determine one or more corrections to the patterning process based on the performance of the lithographic patterning process.
29. An apparatus according to clause 28, wherein the one or more processors are further configured to update the lithographic patterning process with the one or more corrections.
30. An apparatus according to clause 29, wherein updating the lithographic patterning process comprises updating at least one of one or more exposure settings of a lithographic apparatus, and a reticle design.
31. An apparatus according to any of the preceding clauses, wherein the lithographic patterning process is configured to pattern a substrate using a reticle and electromagnetic radiation.
32. An apparatus according to any of the preceding clauses, wherein the one or more processors are further configured to control a metrology apparatus to obtain the image.
33. An apparatus according to clause 32, wherein controlling a metrology apparatus to obtain the image comprises guiding the metrology apparatus is based on previously determined one or more feature characteristics.
34. An apparatus according to clause 32, wherein the metrology apparatus comprises an electron beam imager.
35. A method for determining a performance of a lithographic patterning process, the method comprising:
   receiving an image of a portion of a substrate, the portion of the substrate comprising a first region comprising first features associated with a first lithographic exposure of the substrate at a first time, and a second region comprising second features associated with a second lithographic exposure of the substrate at a second time, wherein the first and second regions do not overlap;
   determining the performance of the lithographic patterning process based on one or more feature characteristics of the first and/or second exposed features associated with a boundary between the first region and the second region.
36. A method according to clause 35, wherein the boundary comprises a portion of an outer border of the first region and a portion of an outer border of the second region.
37. A method according to any of clauses 35 to 36, wherein the first features and the second features comprise at least one of product features, and dummy features having one or more dimensions the same as the product features.
38. A method according to any of clauses 35 to 37, wherein the first features and the second features form a single feature extending along at least part of the first region and at least part of the second region.
39. A method according to any of clauses 35 to 38, wherein the one or more feature characteristics comprises a distance metric comprising:
   a distance between one or more axes of symmetry of the first features and one or more axes of symmetry of the second features; and/or
   a physical distance between the first features and the second features.
40. A method according to clause 38, wherein the one or more feature characteristics comprise a narrowing or a thickening of the single feature at or proximal to the boundary.
41. A method according to any of clauses 35 to 40, wherein the first features and the second features form part of a patterned layer of photoresist or a layer of material after being patterned by an etching process.
42. A method according to any of clauses 35 to 41, wherein determining the performance comprises analysing the image to determine one or more feature characteristics of the first and/or second features associated with the boundary between the first region and the second region.
43. A method according to clause 42, wherein determining the performance comprises performing a comparison of the first and/or second features of the image to a standard for the first and/or second features.
44. A method according to clause 42 or 43, wherein determining the performance further comprises determining a performance of one or more lithographic patterning process characteristics, based on the determined one or more feature characteristics.
45. A method according to clause 44, wherein the one or more feature characteristics comprise a spatial dimension of the first and/or second features.
46. A method according to clause 44 or 45, wherein the one or more process characteristics comprise one or more of magnification, translation, and/or a higher order deformation error associated with the patterning of the first region and/or the second region.
47. A method according to any of clauses 44 to 46, wherein the performance of the one or more process characteristics is determined at least in part using a model taking as input at least one of the one or more feature characteristics.
48. A method according to clause 47, wherein the model comprises a machine learning model.
49. A method according to clause 48, wherein the model comprises a neural network.
50. A method according to clause 49, wherein the model comprises vision technology.
51. A method according to any of the preceding clauses, wherein the first region and the second region form part of a same device on the substrate.
52. A method according to any of clauses 35 to 51, wherein the first region is a first field exposed on the substrate, the second region is a second field exposed on the substrate;
   and wherein the boundary comprises a portion of a border of the first field and a border of the second field.
53. A method according to clause 52, wherein determining the performance comprises determining a stitching error between the first field and the second field.
54. A method according to any of clauses 35 to 53, wherein the received image comprises the substrate in between exposure of subsequent layers on the substrate.
55. A method according to any of clauses 35 to 54, wherein the received image comprises a boundary between the first and second regions extending in at least one direction.
56. A method according to any of clauses 35 to 55, wherein the method further comprises receiving a plurality of images, and determining the quality of the patterning process based on the plurality of images.
57. A method according to clause 56, wherein the plurality of images comprise a first image comprising a boundary between the first and second regions in a first direction, and a second image comprising a boundary between the first region and a further region in a second direction, and wherein the first direction and the second direction are not parallel to each other.
58. A method according to clause 57, wherein the first direction and the second direction are substantially perpendicular to each other.
59. A method according to any of clause 57 to 58, wherein the method further comprises:
   determining a performance of one or more process characteristics for the first image, and determining one or more process characteristics for the second image; and
   combining the one or more process characteristics of the first and second images to determine a performance of the patterning process.
60. A method according to any of clauses 56 to 59, wherein the plurality of images depict a plurality of separate positions on the substrate.
61. A method according to clause 60, wherein one or more process characteristics are determined for the separate positions on the substrate.
62. A method according to any of clauses 35 to 61, wherein the method further comprises determining one or more corrections to the patterning process based on the performance of the lithographic patterning process.
63. A method according to clause 62, wherein the method further comprises updating the lithographic patterning process with the one or more corrections.
64. A method according to clause 63, wherein updating the lithographic patterning process comprises updating at least one of one or more exposure settings of a lithographic apparatus, and a reticle design.
65. A method according to any of clauses 35 to 64, wherein the lithographic patterning process is configured to pattern a substrate using a reticle and electromagnetic radiation.
66. A method according to any of clauses 35 to 65, wherein the method further comprises controlling a metrology apparatus to obtain the image.
67. A method according to clause 66, wherein controlling a metrology apparatus to obtain the image comprises guiding the metrology apparatus is based on previously determined one or more feature characteristics.
68. A method according to clause 66, wherein the metrology apparatus comprises an electron beam imager.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

## Claims

1. A method for determining a performance of a lithographic patterning process, the method comprising:
receiving an image of a portion of a substrate, the portion of the substrate comprising a first region comprising first features associated with a first lithographic exposure of the substrate at a first time, and a second region comprising second features associated with a second lithographic exposure of the substrate at a second time, wherein the first and second regions do not overlap;
determining the performance of the lithographic patterning process based on one or more feature characteristics of the first and/or second exposed features associated with a boundary between the first region and the second region.

2. A method according to claim 1, wherein the boundary comprises a portion of an outer border of the first region and a portion of an outer border of the second region.

3. A method according to claim 1 or 2, wherein the first features and the second features comprise at least one of product features, and dummy features having one or more dimensions the same as the product features.

4. A method according to any of claims 1 to 3, wherein the first features and the second features form a single feature extending along at least part of the first region and at least part of the second region.

5. A method according to any of claims 1 to 4, wherein the one or more feature characteristics comprises a distance metric comprising:
a distance between one or more axes of symmetry of the first features and one or more axes of symmetry of the second features; and/or
a physical distance between the first features and the second features.

6. A method according to claim 5, wherein the one or more feature characteristics comprise a narrowing or a thickening of the single feature at or proximal to the boundary.

7. A method according to any of claims 1 to 6, wherein the first features and the second features form part of a patterned layer of photoresist or a layer of material after being patterned by an etching process.

8. A method according to any of claims 1 to 7, wherein determining the performance comprises analyzing the image to determine one or more feature characteristics of the first and/or second features associated with the boundary between the first region and the second region and further comprises performing a comparison of the first and/or second features of the image to a standard for the first and/or second features.

9. A method according to claim 8, wherein determining the performance further comprises determining a performance of one or more lithographic patterning process characteristics, based on the determined one or more feature characteristics.

10. A method according to claim 9, wherein the one or more process characteristics comprise one or more of magnification, translation, and/or a higher order deformation error associated with the patterning of the first region and/or the second region.

11. A method according to any of claims 44 to 46, wherein the performance of the one or more process characteristics is determined at least in part using a model taking as input at least one of the one or more feature characteristics, wherein the model comprises a machine learning model.

12. A method according to any of the preceding claims, wherein the first region and the second region form part of a same device on the substrate.

13. A method according to any preceding claim, wherein the first region is a first field exposed on the substrate, the second region is a second field exposed on the substrate;
and wherein the boundary comprises a portion of a border of the first field and a border of the second field.

14. A method according to claim 13, wherein determining the performance comprises determining a stitching error between the first field and the second field.

15. A method according to any preceding claim, wherein the method further comprises determining one or more corrections to the patterning process based on the performance of the lithographic patterning process.
